# EUROPEAN PATENT SPECIFICATION

(11) **EP 1 919 059 B1**
(45) Date of publication and mention of the grant of the patent: **14.12.2016**
(21) Application number: 07118940.1
(22) Date of filing: 22.10.2007
(51) Int. Cl.: H02J 7/00, G01R 31/36

(54) **Battery management system and driving method thereof**
System und Antriebsverfahren zur Batterieverwaltung
Système de gestion de batterie et son procédé de commande

(30) Priority: 01.11.2006 KR 20060107222
(43) Date of publication of application: 07.05.2008
(73) Proprietor: Samsung SDI Co., Ltd., Suwon-si Gyeonggi-do (KR)
(72) Inventor: Lim, Gye-Jong, Kyunggi-do (KR); Choi, Soo-Seok, Kyunggi-do (KR); Lee, Young-Jo, Kyunggi-do (KR); Tae, Yong-Jun, Kyunggi-do (KR); Yun, Han-Seok, Kyunggi-do (KR); Seo, Se-Wook, Kyunggi-do (KR); Kim, Beom-Gyu, Kyunggi-do (KR); Park, Ho-Young, Kyunggi-do (KR)
(74) Representative: Gulde & Partner

(56) References cited:
- EP-A- 0 990 913
- EP-A- 1 203 964
- US-A1- 2003 189 419
- US-A1- 2004 257 042

## Description

### BACKGROUND OF THE INVENTION

### Field of the Invention

The present invention relates to a battery management system. More particularly, the present invention relates to a battery management system of a vehicle utilizing electrical energy and a driving method thereof.

### Description of the Related Art

Vehicles using a gasoline or diesel internal combustion engine have caused serious air pollution. Accordingly, various efforts for developing electric or hybrid vehicles have recently been made to reduce air pollution.

An electric vehicle has an electric motor that can be driven by electrical energy that is output by a battery. The main power source of the electric vehicle is a battery, which is formed as a pack that includes a plurality of rechargeable secondary battery cells, and therefore the electric vehicle produces no emission gases and makes less noise than a vehicle using a gasoline or diesel internal combustion engine.

A hybrid vehicle commonly refers to a gasoline-electric hybrid vehicle that has a gasoline combustion engine to produce electricity, and an electric battery that stored the electricity and drives an electric motor with the stored electricity. Recently, hybrid vehicles using an internal combustion engine and fuel cells, and hybrid vehicles using a battery and fuel cells have been developed. The fuel cell directly produces electrical energy through chemical reaction while hydrogen and oxygen are continuously provided to the fuel cell.

In a vehicle using an electric motor, the number of rechargeable batteries or battery cells has increased in order to improve power of the vehicle. Therefore, a cell balancing control method, which is capable of efficiently managing a plurality of coupled battery cells, is required for a battery management system (BMS).

In order to efficiently balance the battery cells, which are coupled to each other, voltage measurement of each battery cell is necessary. The contemporary method of the voltage measurement, however, has a problem in accuracy.

For instance, EP 1 203 964 discloses a method for accurately measuring a battery voltage of each battery block of the battery back.

However, the measuring conditions vary depending on the operation state of the vehicle. Therefore, in order to improve accuracy of the voltage measurement, a voltage detecting method should be performed according to an operation state of the vehicle.

The above information disclosed in this background section is only for enhancement of understanding of the background of the invention and therefore it may contain information that does not form the prior art that is already known to a person of ordinary skill in the art.

### SUMMARY OF THE INVENTION

The present invention has been made in an effort to provide a battery management system having advantages of preventing errors in detection of voltage of a battery cell by controlling the detection process depending on an operation state of a vehicle.

An exemplary embodiment of the present invention provides a battery management system for multiple battery cells of a vehicle. The battery management system includes a sensing unit adapted to be coupled to each of the battery cells and a main control unit coupled to the sensing unit. The sensing unit sequentially detects a voltage of each battery cell according to an adjustable sampling rate. The main control unit determines an operation state of the vehicle, and generates one of at least two sampling signals depending on the operation state of the vehicle. The main control unit transmits the one of at least two sampling signals to the sensing unit.

The sampling signals include a first sampling signal and a second sampling signal. The main control unit generates the first sampling signal whenever the vehicle is in a running state, and generates the second sampling signal whenever the vehicle is in an idle state. A sampling time period of the first sampling signal is shorter than a sampling time period of the second sampling signal.

Each of the first sampling signal and the second sampling signal may include a first control signal having a first level and a second level, a second control signal having a first level and a second level, and a third control signal having a first level and a second level. The first level of the third control signal is applied during a time period in which the first control signal is at the second level of the first control signal and the second control signal is at the second level of the second control signal.

The first level of the first control signal of the first sampling signal is applied during the sampling time period of the first sampling signal, and the first level of the first control signal of the second sampling signal is applied during the sampling time period of the second sampling signal.

Preferably, an absolute value of the first level of the first control signal is larger than an absolute value of the second level of the first control signal.

The sensing unit may include multiple cell relays adapted to be coupled to the plurality of battery cells, the cell relays receiving the first control signal from the main control unit, a first relay coupled to each of the cell relays, the first relay receiving the second control signal from the main control unit, a capacitor coupled to the first relay, a second relay coupled to the capacitor, the second relay receiving the third control signal from the main control unit, and a differential amplification terminal coupled to the second relay, the differential amplification terminal detecting the voltage of each battery cell and amplifying the voltage of each battery cell.

Preferably, each cell relay is turned on to electrically connect the corresponding battery cell to the first relay whenever the first control signal is at the first level, the first relay is turned on to electrically connect the cell relay to the capacitor whenever the second control signal is at the first level, and the second relay is turned on to electrically connect the capacitor to the differential amplification terminal whenever the third control signal is at the first level.

Another exemplary embodiment of the present invention provides a driving method of a battery management system for multiple battery cells of a vehicle including steps of determining an operation state of the vehicle, generating a first sampling signal whenever the vehicle is in a running state, generating a second sampling signal whenever the vehicle is in an idle state, wherein a sampling time period of the first sampling signal is shorter than a sampling time period of the second sampling signal, and sequentially detecting a voltage of each battery cell by applying either the first sampling signal or the second sampling signal to a sensing unit of the battery management system.

The step of detecting a voltage of each battery cell may include steps of turning on one of a plurality of cell relays, each adapted to be coupled to one of the plurality of battery cells during a first time period to electrically connect the corresponding battery cell to a first relay, turning on the first relay during the first time period to electrically connect the cell relay to a capacitor, turning off the cell relay during a second time period to electrically disconnect the first relay from the corresponding battery cell, turning off the first relay during the second time period to electrically disconnect the capacitor from the cell relay, and turning on a second relay that is coupled to the capacitor during the second time period to electrically connect the capacitor to a differential amplifying terminal.

The step of turning on one of the plurality of cell relays may include steps of applying a first level of a first control signal of the first sampling signal whenever the vehicle is in the running state, and applying a first level of a first control signal of the second sampling signal whenever the vehicle is in the idle state. The first level of the first control signal of the first sampling signal is applied during the sampling time period of the first sampling signal, and the first level of the first control signal of the second sampling signal is applied during the sampling time period of the second sampling signal. The step of turning on the first relay may include steps

of applying a first level of a second control signal of the first sampling signal whenever the vehicle is in the running state, and applying a first level of a second control signal of the second sampling signal whenever the vehicle is in the idle state. The step of turning on the second relay may include steps of applying a first level of a third control signal of the first sampling signal whenever the vehicle is in the running state, and applying a first level of a third control signal of the second sampling signal whenever the vehicle is in the idle state.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 schematically illustrates a battery, a battery management system (BMS), and peripheral devices of BMS, which are constructed as an exemplary embodiment of the present invention;
FIG. 2 schematically illustrates a sensing unit and a voltage sensing unit of the BMS, which is constructed as an exemplary embodiment of the present invention; and
FIG. 3 illustrates a waveform of a first control signal, a second control signal, and a third control signal that are generated to control the voltage sensing unit of the BMS, which is constructed as an exemplary embodiment of the present invention.

### DETAILED DESCRIPTION OF THE EMBODIMENTS

In the following detailed description, only exemplary embodiments of the present invention are shown and described, simply by way of illustration. As those skilled in the art would realize, the described embodiments may be modified in various different ways, without departing from the scope of the present invention. Accordingly, the drawings and description are to be regarded as illustrative in nature and not restrictive. Like reference numerals designate like elements throughout the specification.

Throughout this specification and the claims, when it is described that an element is "coupled to" another element, the element may be "directly coupled" to the another element or "indirectly coupled" to the another element through a third element. Throughout this specification and the claims which follow, unless explicitly described to the contrary, the word "comprise/include", or variations such as "comprises/includes" or "comprising/including", will be understood to imply the inclusion of stated elements but not the exclusion of any other elements.

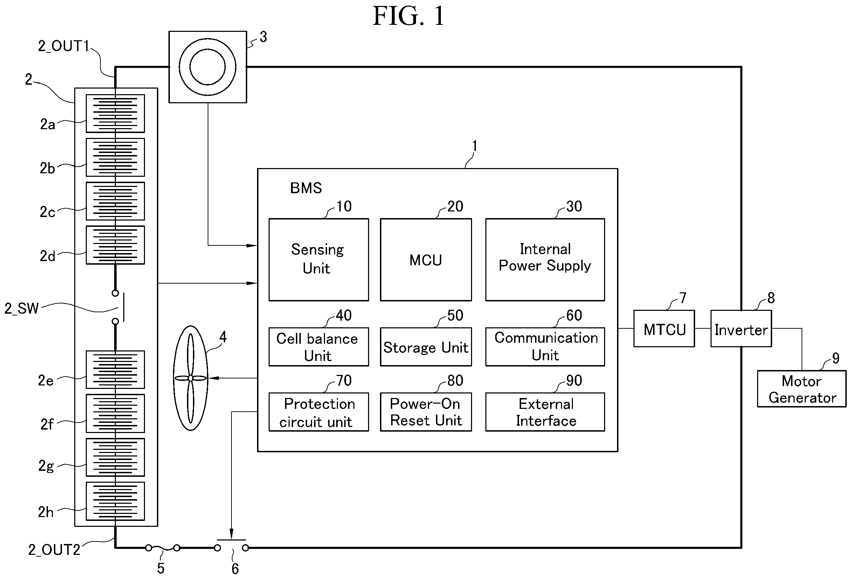

FIG. 1 schematically illustrates a battery, a battery management system, and peripheral devices thereof. As shown in FIG. 1, a motor system includes a battery management system (BMS) 1, a battery 2, a current sensor 3, a cooling fan 4, a fuse 5, a main switch 6, a motor control unit (MTCU) 7, an inverter 8, and a motor generator 9.

The battery 2 includes a plurality of sub-packs 2a to 2h, each of which includes a plurality of battery cells coupled in series with each other. Output terminals 2_OUT1 and 2_OUT2 are formed at ends of the battery 2, and a safety switch 2_SW is provided between sub-pack 2d and sub-pack 2e. Herein, eight sub-packs 2a to 2h are exemplarily illustrated, and each sub-pack is formed by grouping a plurality of battery cells in one group, but the number of sub-packs and the number of battery cells included in each sub-pack are not restrictive. The safety switch 2_SW, which is provided between sub-pack 2d and sub-pack 2e, can be manually turned on or off when an user changes a battery or performs a battery-related operation. In the exemplary embodiment, the safety switch 2_SW is provided between sub-pack 2d and sub-pack 2e, but the safety switch 2_SW can be provided between any two sub-packs, and the location of the safety switch 2_SW is not restrictive. Output terminals 2_OUT1 and 2_OUT2 are coupled to the inverter 8.

The current sensor 3 measures an amount of output current of the battery 2, and outputs the measured amount to a sensing unit 10 of the BMS 1. In detail, the current sensor 3 may be provided as a hall current transformer (Hall CT) that measures an amount of output current by using a hall element, and outputs an analog current signal corresponding to the measured amount.

The cooling fan 4, in response to a control signal from the BMS 1, dissipates heat generated during charging/discharging processes of the battery 2. Therefore, the cooling fan 4 prevents deterioration and reduction of charging/discharge efficiency of the battery 2, which can be caused by a temperature increase of the battery 2.

The fuse 5 prevents high current, which may be caused by a disconnection or a short circuit of the battery 2, from being transmitted to the battery 2. That is, when current overflows, the fuse 5 is decoupled so as to interrupt the high current from flowing into the battery 2.

The main switch 6 turns on or turns off the battery 2 in response to a control signal from the BMS 1 or from the MTCU 7, whenever an unusual phenomenon - including over-voltage, over-current, and high temperature - occurs.

The BMS 1 includes a sensing unit 10, a main control unit (MCU) 20, an internal power supply 30, a cell balance unit 40, a storage unit 50, a communication unit 60, a protection circuit unit 70, a power-on reset unit 80, and an external interface 90.

According to an exemplary embodiment of the present invention, an operation state of a vehicle includes a running state and an idle state. A vehicle in this specification is defined to include a transportation means such as an automobile, a locomotive, a boat, and a ship. The running state of the vehicle is defined as a state in which the vehicle is operated for its purpose. The idle state of the vehicle is defined to include a state in which the operation of the vehicle for its purpose stops. Examples of the running state of the vehicle may include driving a car at a predetermined speed. Examples of the idle state of the vehicle may include parking a car with the engine idling.

The sensing unit 10 measures a battery voltage according to a sampling time that depends on the running or the idle state. Hereinafter, a voltage between output terminals of the battery is referred to as a battery voltage. The sensing unit 10 transmits the measured battery voltage to the MCU 20.

The MCU 20 detects an operation state of a vehicle, and sets different sampling times according to the operation state, whenever the BMS 1 measures each cell voltage or each battery module voltage of the battery 2. The MCU 20 performs high-speed sampling in the running state for stability of the battery 2, and performs low-speed sampling in the idle state so as to correctly measure each cell voltage or each battery module voltage.

In addition, the MCU 20 estimates a state of charge (SOC) and a state of health (SOH) of the battery 2 based on the battery voltage transmitted from the sensing unit 10 and accordingly performs charging and discharging of the battery 2.

The internal power supply 30 supplies power to the BMS 1 using a backup battery. The cell balance unit 40 balances the charging stage of each cell. That is, cells that are relatively highly charged are discharged, and cells that are relatively less charged are further charged. The storage unit 50 stores data of a current SOC or SOH when the power source of the BMS 1 is turned off.

The communication unit 60 communicates with the MTCU 7 of the vehicle system. The protection circuit unit 70 is a circuit for protecting the battery 2 from an external impact, an over-current, or low voltage by means of firmware. The power-on reset unit 80 resets the overall system when the power source of the BMS 1 is turned on. The external interface 90 is used for coupling auxiliary devices of the BMS 1, such as the cooling fan 4 and the main switch 6, to the MCU 20. In the present exemplary embodiment, the cooling fan 4 and the main switch 6 are illustrated as auxiliary devices of the BMS 1, but this is not restrictive. Other devices can be further added as auxiliary devices.

The MTCU 7 detects an operation state of a vehicle based on the state of accelerator or brake of the vehicle, or speed information of the vehicle. The MTCU 7, then, determines necessary information such as an amount of torque, and controls an output of the motor-generator 9 in correspondence to the torque information. That is, the MTCU 7 controls an output of the motor generator 9 in accordance with the torque information by controlling the inverter 8. Also, the MTCU 7 receives the SOC of battery 2 from the MCU 20 through the communication unit 60 of the BMS 1, and controls the SOC of the battery 2 to reach a target value (e.g., 55%). For example, when the SOC transmitted from the MCU 20 is lower than 55%, the MTCU 7 controls the electric power of an external source to flow into the battery 2 by controlling the switch of the inverter 8 to thereby charge the battery 2. At this time, a pack current, which is a current flowing from or to the battery 2, may have a positive (+) value. When the SOC is higher than 55%, the MTCU 7 controls the electric power of the battery 2 to flow into the motor generator 9 by controlling the switch of the inverter 8 to discharge the battery 2. At this time, the pack current may have a negative (-) value.

The inverter 8 charges or discharges the battery 2 in response to a control signal of the MTCU 7. Based on the torque information transmitted from the MTCU 7, the motor generator 9 drives the vehicle by using the electrical energy of the battery 2.

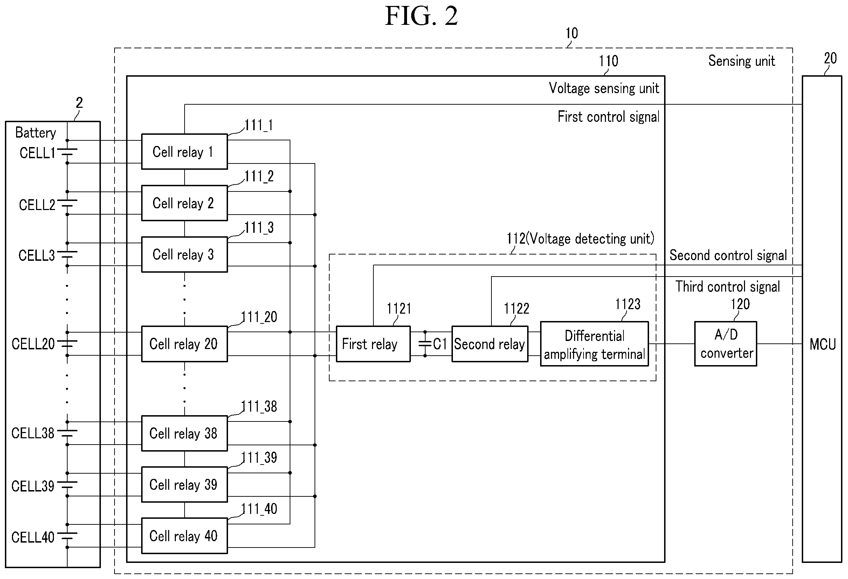

FIG. 2 schematically illustrates a sensing unit 10 and a voltage sensing unit 110, which are constructed as an exemplary embodiment of the present invention. As shown in FIG. 2, the sensing unit 10 includes a voltage sensing unit 110. The voltage sensing unit 110 includes cell relays 111_1 to 111_40, a first relay 1121, a second relay 1122, a capacitor C1, and a differential amplifying terminal 1123. The voltage sensing unit 110 receives first control signals S1_1 to S1_40, a second control signal S2, and a third control signal S3 from the MCU 20. The process of detecting the voltage of each battery cell with control signals S1_1 to S1_40, S2, and S3 will be described in more detail.

The cell relays 111_1 to 111_40 are connected to battery cells CELL1 to CELL40 of the battery 2, respectively. A number of the battery cells can be grouped in a sub-pack as shown in FIG. 1, but the sub-pack is not illustrated in FIG. 2. The cell relay is connected to a positive terminal and a negative terminal of the battery cell. Cell relays 111_1 to 111_40 transmit the voltage of the battery cells (cell voltage) to a voltage detecting unit 112 in response to the first control signals S1_1 to S1_40 transmitted from the MCU 20.

The MCU 20 controls the cell relays 111_1 to 111_40, the first relay 1121, and the second relay 1122, and accordingly enables the voltage detecting unit 112 to detect the voltage of each cell of the battery 2. In an embodiment of the present invention, the MCU 20 generates two different types of sampling signals depending on an operation state of a vehicle. The MCU 20 generates a first sampling signal if the vehicle is in the running state. MCU 20 generates a second sampling signal if the vehicle is in the idle state. Each of the first sampling signal and the second sampling signal includes the first control signal S1_1 to S1_40, the second control signal S2, and the third control signal S3. The controls signals S1_1 to S1_40, S2, and S3 of the first and the second sampling signals, however, have different configurations to efficiently detect the voltages of the battery cells at different operation states of the vehicle.

The MCU 20 generates first control signals S1_1 to S1_40, and transmits the first control signal so as to control the cell relays 111_1 to 111_40. Each of cell relays 111_1 to 111_40 is sequentially turned on to electrically connect the corresponding battery cell to the voltage detecting unit 112 in response to the first control signals S1_1 to S1_40. The voltage detecting unit 112 detects the voltage of the battery cell that is currently connected through the cell relay. In detail, the MCU 20 first identifies whether the vehicle is in a running state or in an idle state. The MCU 20 accordingly generates different first control signals S1_1 to S1_40 based on the identified operation state of the vehicle. Each of the first control signals has a first level and a second level. Each of the cell relays 111_1 to 111_40 is turned on at the first level of the corresponding first control signal, and is turned off at the second level of the corresponding first control signal. Waveforms of the first control signals of the first sampling signal are different from the waveforms of the first control signals of the second sampling signal.

The first control signals S1_1 to S1_40 may be transmitted to the cell relays 111_1 to 111_40, respectively, through multiple transmission lines, each of which transmits the respective first control signal S1_1 to S1_40.

The voltage detecting unit 112 includes the capacitor C1, the first relay 1121, the second relay 1122, and the differential amplification terminal 1123. The first relay 1121 receives the second control signal S2 from the MCU 20, and the second relay 1122 receives the third control signal S3 from the MCU 20. Each of the second control signal S2 and the third control signal S3 has a first level and a second level. The first relay 1121 is turned on at the first level of the second control signal S2, and is turned off at the second level of the second control signal S2. The second relay 1122 is turned on at the first level of the third control signal S3, and is turned off at the second level of the third control signal S3. If the first relay 1121 is turned on, the first relay 1121 receives a cell voltage from one of the cell relays 111_1 to 111_40, and transmits the cell voltage to the capacitor C1. In other words, if the first relay 1121 is turned on, the first relay 1121 electrically connects one of the cell relays 111_1 to 111_40 to the capacitor C1, and if the first relay 1121 is turned off, the first relay 1121 electrically disconnects the capacitor C1 from one of the cell relays 111_1 to 111_40. The procedure of turning on and turning off the second relay 1122 is the same as described for the first relay 1121.

The capacitor C1 stores the cell voltage. If the second relay 1122 is turned on, the second relay 1122 receives the stored cell voltage from the capacitor C1, and transmits the stored cell voltage to the differential amplification terminal 1123. The differential amplification terminal 1123 amplifies the transmitted cell voltage and generates an output voltage.

An A/D converter 120 converts the output voltage transmitted from the differential amplification terminal 1123 to a signal that the MCU 20 can recognize, and transmits the converted signal to the MCU 20.

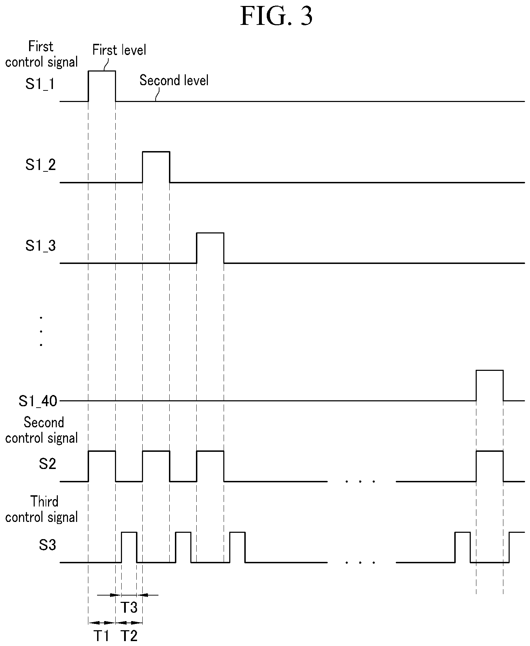

FIG. 3 illustrates waveforms of first control signals S1_1 to S1_40, second control signal S2, and third control signal S3 that are generated to control the voltage sensing unit 110 of the sensing unit 10, which is constructed as an exemplary embodiment of the present invention. The waveforms shown in FIG. 3 are represented as a function of time. As described above, the MCU 20 generates a first sampling signal or a second sampling signal depending on the operation state of the vehicle. The waveforms shown in FIG. 3 are control signals of one of the first sampling signal or the second sampling signal. The difference of the waveforms of the control signals of the first and second sampling signal will be described later.

Each of the first control signals S1_1 to S1_40 has a first level and a second level. According to an exemplary embodiment of the present invention, the first level is set to be higher than the second level, and therefore, the first level can be represented as a pulse as shown in FIG. 3. The time period in which a first level is applied is sequentially arranged among the first control signals S1_1 to S1_40. At a given sampling signal, the cell relays 111_1 to 111_40 receive first control signals S1_1 to S1_40, respectively, from the MCU 20. Each of the cell relays 111_1 to 111_40 is turned on at a time period in which a first level is applied, and is turned off at a time period in which a second level is applied.

As shown in FIG. 3, during a first time period T1, the first control signal S1 and the second control signal S2 are at a first level. Therefore, during the first time period T1, the cell relay 111_1 is turned on in response to the first control signal S1_1, and the first relay 1121 is turned on in response to the second control signal S2. In this case, the battery cell CELL1 is electrically connected to the capacitor C1 through the first relay 1121, and the capacitor C1 is charged in proportion to the voltage of the battery cell CELL1. During the first time period T1, the third control signal S3 is at a second level, and therefore the second relay 1122 is in a turn-off state in response to the third control signal S3.

During a second time period T2, the cell relay 111_1 and the first relay 1121 are turned off in response to the first control signal S1_1 and the second control signal S2, respectively, while the second relay 1122 is turned on in response to the third control signal S3. The third control signal S3 is at a first level during a third time period T3, which is a sub-interval of the second time period T2. Accordingly, the second relay 1122 transmits the charges stored in the capacitor C1, which represents the voltage of the battery cell CELL1, to the differential amplification terminal 1123.

According to an exemplary embodiment of the present invention, the time periods T2 and T3 can be established by considering the magnitude of the capacitance of capacitor C1 and the response speeds of the first relay 1121 and the second relay 1122.

The same operations as applied during the time period T1 and T2 are repeated with other first control signals S1_2 through S1_40 until the rest of the cell relays 111_2 to 111_40 respond to the corresponding control signals.

In an embodiment of the present invention, the MCU 20 adjusts the length of first time period T1 to switch from one sampling signal to another sampling signal. In one embodiment, the first sampling signal has a shorter time period T1 than the second sampling signal. Therefore, in this case, if the vehicle is in a running state, the MCU 20 generates a first sampling signal and the total detection time period, which is required to detect the voltages of the battery cells CELL1 to CELL40, becomes shorter. The total detection time period required to detect the voltages of the battery cells can be referred to as a sampling time. Therefore, the first sampling signal corresponds to a high speed sampling. On the other hand, if the vehicle is in an idle state, the MCU 20 generates a second sampling signal. Because the first time period T1 of the second sampling signal is longer than that of the first sampling signal, the total detection time period, which is required to detect the voltages of the battery cells CELL1 to CELL40, becomes longer. Therefore, the second sampling signal corresponds to a low speed sampling.

The second control signal S2 is input from the MCU 20 to control the first relay 1121. During the first time period T1, a first level of the second control signal S2 is applied, and the first relay 1121 is turned on. Therefore, the voltage of the battery cell is applied to the voltage detecting unit 112, and is transmitted to the capacitor C1. During the second time period T2, the cell relays 111_1 to 111_40 and the first relay 1121 are turned off. Therefore, the cell voltage stored in the capacitor C1 is not interrupted. Moreover, in the second time period T2, the second relay 1122 is turned on during the third time period T3. Therefore, the cell voltage stored in the capacitor C1 is transmitted to the differential amplification terminal 1123.

According to an exemplary embodiment of the present invention, the number of cells of the battery is given as forty, but the number is not limited thereto. Accordingly, the number of cell relays may be changed in correspondence to the total number of the battery cells.

In a battery management system and a driving method thereof using a voltage detecting unit, which is constructed as an exemplary embodiment of the present invention, cell voltage detection is performed according to an operation state of a vehicle. Cell voltage detection is performed at high speed for the stability of the battery during the driving of the vehicle, and is performed at low speed for the accurate detection of the cell voltage when the vehicle is stopped or parked.

According to an exemplary embodiment of the present invention, the battery voltage is measured while the sampling time is differently controlled on a running and idle state. A battery voltage may be more accurately measured when stability is improved in the running state of the vehicle, and may be more accurately measured when a stabilizing time of the capacitor is improved in the idle state.

## Claims

1. A battery management system (1) for multiple battery cells (CELL1,..., CELL40) of a vehicle, the system comprising:
a sensing unit (10) for sequentially detecting a voltage of each battery cell (CELL1,..., CELL40) according to an adjustable sampling rate; **characterized in that** there is
a main control unit (20) coupled to the sensing unit (10), the main control unit (20) determining an operation state of the vehicle, the main control unit (20) generating one of at least two sampling signals depending on the operation state of the vehicle, the main control unit (20) transmitting the one of at least two sampling signals to the sensing unit (10), wherein the sampling signals include a first sampling signal and a second sampling signal, wherein a sampling time period of the first sampling signal is shorter than a sampling time period of the second sampling signal, wherein the first and second sampling signals comprise a first control signal, a second control signal, and a third control signal and
wherein the main control unit (20) generates the first sampling signal whenever the vehicle is in a running state, and generates the second sampling signal whenever the vehicle is in an idle state, and
the sensing unit(10) further comprises:
multiple cell relays (111_1,..., 111_40) adapted to be coupled to the battery cells (CELL1,..., CELL40), the cell relays (111_1,..., 111_40) receiving the first control signal (S1_1,..., S1_40) from the main control unit (20);
a first relay (1121) coupled to each of the cell relays (111_1,..., 1111_40), the first relay (1121) receiving the second control signal (S2) from the main control unit (20);
a capacitor (C1) coupled to the first relay (1121);
a second relay (1122) coupled to the capacitor (C1), the second relay (1122) receiving the third control signal (S3) from the main control unit (20); and
a differential amplification terminal (1123) coupled to the second relay (1122), the differential amplification terminal (1123) detecting the voltage of each battery cell (CELL1,..., CELL40) and amplifying the voltage of each battery cell (CELL1,..., CELL40).

2. The battery management system of claim 1, wherein:
the first control signal (S1_1,..., S1_40) having a first level and a second level;
the second control signal (S2) having a first level and a second level; and
the third control signal (S3) having a first level and a second level, the first level of the third control signal (S3) being applied during a time period in which the first control signal (S1_1,..., S1_40) is at the second level of the first control signal (S1_1,..., S1_40) and the second control signal (S2) is at the second level of the second control signal (S2).

3. The battery management system of claim 2, wherein:
the first level of the first control signal (S1_1,..., S1_40) of the first sampling signal is applied during the sampling time period of the first sampling signal, and the first level of the first control signal (S1_1,..., S1_40) of the second sampling signal is applied during the sampling time period of the second sampling signal.

4. The battery management system of one of claims 2 and 3, wherein an absolute value of the first level of the first control signal (S1_1,..., S1_40) is larger than an absolute value of the second level of the first control signal (S1_1,..., S1_40).

5. The battery management system of claim 2, wherein:
each cell relay (111_1,..., 111_40) is turned on to electrically connect the corresponding battery cell (CELL1,..., CELL40) to the first relay (1121) whenever the first control signal (S1_1,..., S1_40) is at the first level;
the first relay (1121) is turned on to electrically connect the cell relay (111_1,..., 111_40) to the capacitor (C1) whenever the second control signal (S2) is at the first level; and
the second relay (1122) is turned on to electrically connect the capacitor (C1) to the differential amplification terminal (1123) whenever the third control signal (S3) is at the first level.

6. A method for using a battery management system for multiple battery cells (CELL1,..., CELL40) of a vehicle, the method comprising:
determining an operation state of the vehicle;
**characterized in that** there are the steps of
generating a first sampling signal whenever the vehicle is in a running state;
generating a second sampling signal whenever the vehicle is in an idle state, wherein a sampling time period of the first sampling signal is shorter than a sampling time period of the second sampling signal; and
sequentially detecting a voltage of each battery cell (CELL1,..., CELL40) by applying either the first sampling signal or the second sampling signal to a sensing unit (10) of the battery management system (1), and
the step of detecting a voltage of each battery cell (CELL1,..., CELL40) further comprises:
turning on one of a plurality of cell relays (111_1,..., 111_40) that is adapted to be coupled to one of the plurality of battery cells (CELL1,..., CELL40) during a first time period (T1) to electrically connect the corresponding battery cell (CELL1,..., CELL40) to a first relay (1121);
turning on the first relay (1121) during the first time (T1) period to electrically connect the cell relay (111_1,..., 111_40) to a capacitor (C1);
turning off the cell relay (111_1,..., 111_40) during a second time period (T2) to electrically disconnect the first relay (1121) from the corresponding battery cell (CELL1,..., CELL40);
turning off the first relay (1121) during the second time period (T2) to electrically disconnect the capacitor (C1) from the cell relay (111_1,..., 111_40); and
turning on a second relay (1122) that is coupled to the capacitor (C1) during a third time period (T3) within the second time period (T2) to electrically connect the capacitor (C1) to a differential amplifying terminal (1123).

7. The method of claim 6, wherein the step of turning on one of the plurality of cell relays (111_1,..., 111_40) comprises:
applying a first level of a first control signal (S1_1,..., S1_40) of the first sampling signal whenever the vehicle is in the running state; and
applying a first level of a first control signal (S1_1,..., S1_40) of the second sampling signal whenever the vehicle is in the idle state.

8. The method of claim 7, wherein:
the first level of the first control signal (S1_1,..., S1_40) of the first sampling signal is applied during the sampling time period of the first sampling signal, and the first level of the first control signal (S1_1,..., S1_40) of the second sampling signal is applied during the sampling time period of the second sampling signal.

9. The method of one of claims 6 through 8, wherein the step of turning on the first relay (1121) comprises:
applying a first level of a second control signal (S2) of the first sampling signal whenever the vehicle is in the running state; and
applying a first level of a second control signal (S2) of the second sampling signal whenever the vehicle is in the idle state.

10. The method of one of claims 6 through 9, wherein the step of turning on the second relay (1122) comprises:
applying a first level of a third control signal (S3) of the first sampling signal whenever the vehicle is in the running state; and
applying a first level of a third control signal (S3) of the second sampling signal whenever the vehicle is in the idle state.

## Patentansprüche

1. Batterieverwaltungssystem (1) für mehrere Batteriezellen (CELL1, ..., CELL40) für ein Fahrzeug, wobei das System aufweist:
eine Abtasteinheit (10) zum sequenziellen Erfassen einer Spannung jeder Batteriezelle (CELLI, ..., CELL40) gemäß einer einstellbaren Abtastrate;
**dadurch gekennzeichnet, dass** eine Hauptsteuereinheit (20) vorgesehen ist, die mit der Abtasteinheit (10) gekoppelt ist, wobei die Hauptsteuereinheit (20) einen Betriebszustand des Fahrzeugs bestimmt, wobei die Hauptsteuereinheit (20) eines von zumindest zwei Abtastsignalen in Abhängigkeit vom Betriebszustand des Fahrzeugs erzeugt, wobei die Hauptsteuereinheit (20) das eine der zumindest zwei Abtastsignale zur Abtasteinheit (10) übermittelt, wobei die Abtastsignale ein erstes Abtastsignal und ein zweites Abtastsignal aufweisen, wobei eine Abtastzeitdauer des ersten Abtastsignals kürzer als eine Abtastzeitdauer des zweiten Abtastsignals ist, wobei das erste und zweite Abtastsignal ein erstes Steuersignal, ein zweites Steuersignal und ein drittes Steuersignal aufweisen und wobei die Hauptsteuereinheit (20) das erste Abtastsignal immer dann erzeugt, wenn das Fahrzeug in einem Fahrzustand ist, und das zweite Abtastsignal immer dann erzeugt, wenn das Fahrzeug in einem Leerlaufzustand ist, und
wobei die Abtasteinheit (10) ferner aufweist:
mehrere Zellen-Relais (111_1, ..., 111_40), die angepasst sind, um mit den Batteriezellen (CELLI, ..., CELL40) gekoppelt zu werden, wobei die Zellen-Relais (111_1, ..., 111_40) das erste Steuersignal (S1_1, ..., S1_40) von der Hauptsteuereinheit (20) empfangen;
ein erstes Relais (1121), das mit jedem der Zellen-Relais (111_1, ..., 111_40) gekoppelt ist, wobei das erste Relais (1121) das zweite Steuersignal (S2) von der Hauptsteuereinheit (20) empfängt;
einen Kondensator (C1), der mit dem ersten Relais (1121) gekoppelt ist;
ein zweites Relais (1122), das mit dem Kondensator (C1) gekoppelt ist, wobei das zweite Relais (1122) das dritte Steuersignal (S3) von der Hauptsteuereinheit (20) empfängt; und
einen Differenzverstärkungsanschluss (1123), der mit dem zweiten Relais (1122) gekoppelt ist, wobei der Differenzverstärkungsanschluss (1123) die Spannung jeder Batteriezelle (CELL1, ..., CELL40) erfasst und die Spannung jeder Batteriezelle (CELL1, ..., CELL40) verstärkt.

2. Batterieverwaltungssystem nach Anspruch 1, wobei:
das erste Steuersignal (S1_1, ..., S1_40) einen ersten Pegel und einen zweiten Pegel aufweist;
das zweite Steuersignal (S2) einen ersten Pegel und einen zweiten Pegel aufweist; und
das dritte Steuersignal (S3) einen ersten Pegel und einen zweiten Pegel aufweist, wobei der erste Pegel des dritten Steuersignals (S3) während einer Zeitdauer, während der das erste Steuersignal (S1_1, ..., S1_40) auf dem zweiten Pegel des ersten Steuersignals (S1_1, ..., S1_40) ist, und das zweite Steuersignal (S2) auf dem zweiten Pegel des zweiten Steuersignals (S2) ist, anliegt.

3. Batterieverwaltungssystem nach Anspruch 2, wobei:
der erste Pegel des ersten Steuersignals (S1_2, ..., S1_40) des ersten Abtastsignals während der Abtastzeitdauer des ersten Abtastsignals anliegt, und der erste Pegel des ersten Steuersignals (S1_1, ..., S1_40) des zweiten Abtastsignals während der Abtastzeitdauer des zweiten Abtastsignals anliegt.

4. Batterieverwaltungssystem nach einem der Ansprüche 2 und 3, wobei ein absoluter Wert des ersten Pegels des ersten Steuersignals (S1_1, ..., S1_40) größer als ein absoluter Wert des zweiten Pegels des ersten Steuersignals (S1_1, ..., S1_40) ist.

5. Batterieverwaltungssystem nach Anspruch 2, wobei:
jedes Zellen-Relais (111_1, ..., 111_40) angeschaltet wird, um die entsprechende Batteriezelle (CELL1, ..., CELL40) immer dann mit dem ersten Relais (1121) elektrisch zu verbinden, wenn das erste Steuersignal (S1_1, ..., S1_40) auf dem ersten Pegel ist;
das erste Relais (1121) angeschaltet wird, um das Zellen-Relais (111_1, ..., 111_40) immer dann mit dem Kondensator (C1) elektrisch zu verbinden, wenn das zweite Steuersignal (S2) auf dem ersten Pegel ist; und
das zweite Relais (1122) angeschaltet wird, um den Kondensator (C1) immer dann mit dem Differenzverstärkungsanschluss (1123) elektrisch zu verbinden, wenn das dritte Steuersignal (S3) auf dem ersten Pegel ist.

6. Verfahren zur Verwendung eines Batterieverwaltungssystems für mehrere Batteriezellen (CELL1, ..., CELL40) für ein Fahrzeug, wobei das Verfahren aufweist:
Bestimmen eines Betriebszustands des Fahrzeugs;
**dadurch gekennzeichnet, dass** die Schritte vorgesehen sind zum
Erzeugen eines ersten Abtastsignals immer dann, wenn das Fahrzeug in einem Fahrzustand ist;
Erzeugen eines zweiten Abtastsignals immer dann, wenn das Fahrzeug in einem Leerlaufzustand ist, wobei eine Abtastzeitdauer des ersten Abtastsignals kürzer als eine Abtastzeitdauer des zweiten Abtastsignals ist; und
sequentiellen Erfassen einer Spannung jeder Batteriezelle (CELL1, ..., CELL40) durch Anlegen entweder des ersten Abtastsignals oder des zweiten Abtastsignals an eine Abtasteinheit (10) des Batterieverwaltungssystems (1), und
wobei der Schritt des Erfassens einer Spannung jeder Batteriezelle (CELL1, ..., CELL40) ferner aufweist:
Anschalten eines einer Vielzahl von Zellen-Relais (111_1, ..., 111_40), das angepasst ist, um während einer ersten Zeitdauer mit einer der Vielzahl der Batteriezellen (CELL1, ..., CELL40) gekoppelt zu werden, um die entsprechende Batteriezelle (CELL1, ..., CELL40) mit einem ersten Relais (1121) elektrisch zu verbinden;
Anschalten des ersten Relais (1121) während der ersten Zeitdauer (T1), um das Zellen-Relais (111_1, ..., 111_40) mit einem Kondensator (C1) elektrisch zu verbinden;
Abschalten des Zellen-Relais (111_1, ..., 111_40) während einer zweiten Zeitdauer (T2), um das erste Relais (1121) von der entsprechenden Batteriezelle (CELL1, ..., CELL40) elektrisch zu trennen;
Abschalten des ersten Relais (1121) während der zweiten Zeitdauer (T2), um den Kondensator (C1) vom Zellen-Relais (111_1, ..., 111_40) elektrisch zu trennen; und
Anschalten eines zweiten Relais (1122), das mit dem Kondensator (C1) gekoppelt ist, während einer dritten Zeitdauer (T3) innerhalb der zweiten Zeitdauer (T2), um den Kondensator (C1) mit einem Differenzverstärkungsanschluss (1123) elektrisch zu verbinden.

7. Verfahren nach Anspruch 6, wobei der Schritt des Anschaltens eines der Vielzahl der Zellen-Relais (111_1, ..., 111_40) aufweist:
Anlegen eines ersten Pegels eines ersten Steuersignals (S1_1, ..., S1_40) des ersten Abtastsignals immer dann, wenn das Fahrzeug im Fahrzustand ist; und
Anlegen eines ersten Pegels eines ersten Steuersignals (S1_1, ..., S1_40) des zweiten Abtastsignals immer dann, wenn das Fahrzeug im Leerlaufzustand ist.

8. Verfahren nach Anspruch 7, wobei:
der erste Pegel des ersten Steuersignals (S1_1, ..., S1_40) des ersten Abtastsignals während der Abtastzeitdauer des ersten Abtastsignals anliegt und der erste Pegel des ersten Steuersignals (S1_1, ..., S1_40) des zweiten Abtastsignals während der Abtastzeitdauer des zweiten Abtastsignals anliegt.

9. Verfahren nach einem der Ansprüche 6 bis 8, wobei der Schritt des Anschaltens des ersten Relais (1121) aufweist:
Anlegen eines ersten Pegels eines zweiten Steuersignals (S2) des ersten Abtastsignals immer dann, wenn das Fahrzeug im Fahrzustand ist, und
Anlegen eines ersten Pegels eines zweiten Steuersignals (S2) des zweiten Abtastsignals immer dann, wenn das Fahrzeug im Leerlaufzustand ist.

10. Verfahren nach einem der Ansprüche 6 bis 9, wobei der Schritt des Anschaltens des zweiten Relais (1122) aufweist:
Anlegen eines ersten Pegels eines dritten Steuersignals (S3) des ersten Abtastsignals immer dann, wenn das Fahrzeug im Fahrzustand ist; und
Anlegen eines ersten Pegels eines dritten Steuersignals (S3) des zweiten Abtastsignals immer dann, wenn das Fahrzeug im Leerlaufzustand ist.

## Revendications

1. Système de gestion de batterie (1) pour de multiples cellules de batterie (CELL1, ..., CELL40) d'un véhicule, le système comprenant :
une unité de détection (10) pour détecter de manière séquentielle une tension de chaque cellule de batterie (CELL1, ..., CELL40) conformément à une fréquence d'échantillonnage ajustable ;
**caractérisé en ce qu'**il y a
une unité de commande principale (20) couplée à l'unité de détection (10), l'unité de commande principale (20) déterminant un état de fonctionnement du véhicule, l'unité de commande principale (20) générant l'un d'au moins deux signaux d'échantillonnage en fonction de l'état de fonctionnement du véhicule, l'unité de commande principale (20) transmettant ledit un d'au moins deux signaux d'échantillonnage à l'unité de détection (10), dans lequel les signaux d'échantillonnage comprennent un premier signal d'échantillonnage et un deuxième signal d'échantillonnage, dans lequel une période de temps d'échantillonnage du premier signal d'échantillonnage est plus courte qu'une période de temps d'échantillonnage du deuxième signal d'échantillonnage, dans lequel les premier et deuxième signaux d'échantillonnage comprennent un premier signal de commande, un deuxième signal de commande et un troisième signal de commande, et
dans lequel l'unité de commande principale (20) génère le premier signal d'échantillonnage à chaque fois que le véhicule est dans un état de fonctionnement, et génère le deuxième signal d'échantillonnage à chaque fois que le véhicule est dans un état de ralenti, et
l'unité de détection (10) comprend en outre :
de multiples relais de cellule (111_1, ..., 111_40) conçus pour être couplés aux cellules de batterie (CELL1, ..., CELL40), les relais de cellule (111_1, ..., 111_40) recevant le premier signal de commande (S1_1, ..., S1_40) de l'unité de commande principale (20) ;
un premier relais (1121) couplé à chacun des relais de cellule (111_1, ..., 111_40), le premier relais (1121) recevant le deuxième signal de commande (S2) de l'unité de commande principale (20) ;
un condensateur (C1) couplé au premier relais (1121) ;
un deuxième relais (1122) couplé au condensateur (C1), le deuxième relais (1122) recevant le troisième signal de commande (S3) de l'unité de commande principale (20) ; et
un terminal d'amplification différentielle (1123) couplé au deuxième relais (1122), le terminal d'amplification différentielle (1123) détectant la tension de chaque cellule de batterie (CELL1, ..., CELL40) et amplifiant la tension de chaque cellule de batterie (CELL1, ..., CELL40).

2. Système de gestion de batterie selon la revendication 1, dans lequel :
le premier signal de commande (S1_1, ..., S1_40) a un premier niveau et un deuxième niveau ;
le deuxième signal de commande (S2) a un premier niveau et un deuxième niveau ; et
le troisième signal de commande (S3) a un premier niveau et un deuxième niveau, le premier niveau du troisième signal de commande (S3) étant appliqué pendant une période de temps dans laquelle le premier signal de commande (S1_1, ..., S1_40) est au deuxième niveau du premier signal de commande (S1_1, ..., S1_40) et le deuxième signal de commande (S2) est au deuxième niveau du deuxième signal de commande (S2).

3. Système de gestion de batterie selon la revendication 2, dans lequel :
le premier niveau du premier signal de commande (S1_1, ..., S1_40) du premier signal d'échantillonnage est appliqué pendant la période de temps d'échantillonnage du premier signal d'échantillonnage, et le premier niveau du premier signal de commande (S1_1, ..., S1_40) du deuxième signal d'échantillonnage est appliqué pendant la période de temps d'échantillonnage du deuxième signal d'échantillonnage.

4. Système de gestion de batterie selon l'une des revendications 2 et 3, dans lequel une valeur absolue du premier niveau du premier signal de commande (S1_1, ..., S1_40) est plus grande qu'une valeur absolue du deuxième niveau du premier signal de commande (S1_1, ..., S1_40).

5. Système de gestion de batterie selon la revendication 2, dans lequel :
chaque relais de cellule (111_1, ..., 111_40) est activé pour connecter électriquement la cellule de batterie (CELL1, ..., CELL40) correspondante au premier relais (1121) à chaque fois que le premier signal de commande (S1_1, ..., S1_40) est au premier niveau ;
le premier relais (1121) est activé pour connecter électriquement le relais de cellule (111_1, ..., 111_40) au condensateur (C1) à chaque fois que le deuxième signal de commande (S2) est au premier niveau ; et
le deuxième relais (1122) est activé pour connecter électriquement le condensateur (C1) au terminal d'amplification différentielle (1123) à chaque fois que le troisième signal de commande (S3) est au premier niveau.

6. Procédé d'utilisation d'un système de gestion de batterie pour de multiples cellules de batterie (CELL1, ..., CELL40) d'un véhicule, le procédé comprenant :
la détermination d'un état de fonctionnement du véhicule ;
**caractérisé en ce qu'**il y a les étapes :
de génération d'un premier signal d'échantillonnage à chaque fois que le véhicule est dans un état de fonctionnement ;
de génération d'un deuxième signal d'échantillonnage à chaque fois que le véhicule est dans un état de ralenti, dans lequel une période de temps d'échantillonnage du premier signal d'échantillonnage est plus courte qu'une période de temps d'échantillonnage du deuxième signal d'échantillonnage ; et
de détection de manière séquentielle d'une tension de chaque cellule de batterie (CELL1, ..., CELL40) en appliquant soit le premier signal d'échantillonnage, soit le deuxième signal d'échantillonnage à une unité de détection (10) du système de gestion de batterie (1), et
l'étape de détection d'une tension de chaque cellule de batterie (CELL1, ..., CELL40) comprend en outre :
l'activation de l'un d'une pluralité de relais de cellule (111_1, ..., 111_40) qui est conçu pour être couplé à l'une de la pluralité de cellules de batterie (CELL1, ..., CELL40) pendant une première période de temps (T1) pour connecter électriquement la cellule de batterie (CELL1, ..., CELL40) correspondante à un premier relais (1121) ;
l'activation du premier relais (1121) pendant la première période de temps (T1) pour connecter électriquement le relais de cellule (111_1, ..., 111_40) à un condensateur (C1) ;
la désactivation du relais de cellule (111_1, ..., 111_40) pendant une deuxième période de temps (T2) pour déconnecter électriquement le premier relais (1121) de la cellule de batterie (CELL1, ..., CELL40) correspondante ;
la désactivation du premier relais (1121) pendant la deuxième période de temps (T2) pour déconnecter électriquement le condensateur (C1) du relais de cellule (111_1, ..., 111_40) ; et
l'activation d'un deuxième relais (1122) qui est couplé au condensateur (C1) pendant une troisième période de temps (T3) dans la deuxième période de temps (T2) pour connecter électriquement le condensateur (C1) à un terminal d'amplification différentielle (1123).

7. Procédé selon la revendication 6, dans lequel l'étape d'activation de l'un de la pluralité de relais de cellule (111_1, ..., 111_40) comprend :
l'application d'un premier niveau d'un premier signal de commande (S1_1, ..., S1_40) du premier signal d'échantillonnage à chaque fois que le véhicule est dans l'état de fonctionnement ; et
l'application d'un premier niveau d'un premier signal de commande (S1_1, ..., S1_40) du deuxième signal d'échantillonnage à chaque fois que le véhicule est dans l'état de ralenti.

8. Procédé selon la revendication 7, dans lequel :
le premier niveau du premier signal de commande (S1_1, ..., S1_40) du premier signal d'échantillonnage est appliqué pendant la période de temps d'échantillonnage du premier signal d'échantillonnage, et le premier niveau du premier signal de commande (S1_1, ..., S1_40) du deuxième signal d'échantillonnage est appliqué pendant la période de temps d'échantillonnage du deuxième signal d'échantillonnage.

9. Procédé selon l'une des revendications 6 à 8, dans lequel l'étape d'activation du premier relais (1121) comprend :
l'application d'un premier niveau d'un deuxième signal de commande (S2) du premier signal d'échantillonnage à chaque fois que le véhicule est dans l'état de fonctionnement ; et
l'application d'un premier niveau d'un deuxième signal de commande (S2) du deuxième signal d'échantillonnage à chaque fois que le véhicule est dans l'état de ralenti.

10. Procédé selon l'une des revendications 6 à 9, dans lequel l'étape d'activation du deuxième relais (1122) comprend :
l'application d'un premier niveau d'un troisième signal de commande (S3) du premier signal d'échantillonnage à chaque fois que le véhicule est dans l'état de fonctionnement ; et
l'application d'un premier niveau d'un troisième signal de commande (S3) du deuxième signal d'échantillonnage à chaque fois que le véhicule est dans l'état de ralenti.
